(19) **Europäisches Patentamt / European Patent Office / Office européen des brevets**

(11) **EP 4 084 060 B1**

(12) **EUROPEAN PATENT SPECIFICATION**

(45) Date of publication and mention of the grant of the patent:
**13.11.2024 Bulletin 2024/46**

(21) Application number: **21781186.8**

(22) Date of filing: **26.03.2021**

(51) International Patent Classification (IPC):
**H01L 23/373** (2006.01)     **C04B 38/00** (2006.01)
**C04B 41/83** (2006.01)     **C04B 35/583** (2006.01)
**H05K 7/20** (2006.01)     **C04B 35/626** (2006.01)
**C04B 41/00** (2006.01)     **C04B 41/48** (2006.01)
**C08K 3/38** (2006.01)     **H01L 23/15** (2006.01)
**C04B 35/64** (2006.01)

(52) Cooperative Patent Classification (CPC):
(C-Sets available)
**H01L 23/3731; C04B 35/583; C04B 35/62675;**
**C04B 35/62685; C04B 38/00; C04B 41/009;**
**C04B 41/48; C04B 41/4853; C04B 41/83;**
**C08K 3/38; H01L 23/15; H01L 23/3733;**
C04B 35/62615; C04B 35/64; C04B 2201/32;

(Cont.)

(86) International application number:
**PCT/JP2021/013053**

(87) International publication number:
**WO 2021/200724 (07.10.2021 Gazette 2021/40)**

(54) **BORON NITRIDE SINTERED BODY, COMPOSITE BODY, METHOD FOR PRODUCING SAID BORON NITRIDE SINTERED BODY AND METHOD FOR PRODUCING SAID COMPOSITE BODY**

SINTERKÖRPER AUS BORNITRID, VERBUNDKÖRPER, VERFAHREN ZUR HERSTELLUNG DES GESINTERTEN BORNITRIDKÖRPERS UND VERFAHREN ZUR HERSTELLUNG DES VERBUNDKÖRPERS

CORPS FRITTÉ AU NITRURE DE BORE, CORPS COMPOSITE, PROCÉDÉ DE PRODUCTION DUDIT CORPS FRITTÉ AU NITRURE DE BORE ET PROCÉDÉ DE PRODUCTION DUDIT CORPS COMPOSIT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.03.2020 JP 2020064585**

(43) Date of publication of application:
**02.11.2022 Bulletin 2022/44**

(73) Proprietor: **Denka Company Limited**
**Tokyo 103-8338 (JP)**

(72) Inventors:
• **IKARASHI, Koki**
**Tokyo 103-8338 (JP)**

• **TAKEDA, Makoto**
**Tokyo 103-8338 (JP)**
• **KOBASHI, Seiji**
**Tokyo 103-8338 (JP)**
• **NISHIMURA, Koji**
**Tokyo 103-8338 (JP)**

(74) Representative: **Hoffmann Eitle**
**Patent- und Rechtsanwälte PartmbB**
**Arabellastraße 30**
**81925 München (DE)**

(56) References cited:
**WO-A1-2014/136959     WO-A1-2014/196496**
**WO-A1-2017/034003     JP-A- 2005 343 728**
**JP-A- 2017 165 609     JP-A- 2019 073 409**

EP 4 084 060 B1

**JP-A- 2019 525 883**     **US-A1- 2018 230 352**
**US-A1- 2019 092 695**

(52) Cooperative Patent Classification (CPC): (Cont.)
C04B 2235/3208; C04B 2235/3409;
C04B 2235/3821; C04B 2235/3856;
C04B 2235/386; C04B 2235/422; C04B 2235/5436;
C04B 2235/6586; C04B 2235/783; C04B 2235/786;
C04B 2235/787; C04B 2235/94; C04B 2235/95;
C04B 2235/96; C04B 2235/9607; C08K 2003/385;
H01L 23/3737

C-Sets
**C04B 38/00, C04B 35/583, C04B 38/0054,
C04B 38/0074;
C04B 41/009, C04B 35/583, C04B 38/00**

## Description

### Technical Field

The present disclosure relates to a boron nitride sintered body, a composite body, and manufacturing methods therefor, and a heat dissipation member.

### Background Art

In components such as a power device, a transistor, a thyristor, and a CPU, efficient dissipation of heat generated during use thereof is required. From such a request, conventionally, a thermal conductivity of an insulating layer of a printed-wiring board onto which an electronic component is to be mounted has been improved, or an electronic component or a printed-wiring board has been mounted onto a heat sink via thermal interface materials having electrical insulation properties. A composite body (heat dissipation member) configured by a resin and ceramic such as boron nitride is used for the insulating layer and the thermal interface material described above.

Boron nitride has lubricity, high thermal conducting properties, electrical insulation properties, and the like, and from this aspect, it has been studied to use ceramic containing boron nitride for a heat dissipation member. Patent Literature 1 has proposed a technique of adjusting an orientation degree and a graphitization index in predetermined ranges to decrease the anisotropy of the thermal conductivity while attaining an excellent thermal conductivity. Patent Literature 2 has proposed a technique of manufacturing a heat dissipation member using a lump boron nitride powder. Patent Literature 3 proposes a boron nitride sintered body with intersecting coarse particles which surround fine particles.

### Citation List

### Patent Literature

Patent Literature 1: Japanese Unexamined Patent Publication No. 2014-162697
Patent Literature 2: Japanese Unexamined Patent Publication No. 2019-73409 Patent Literature 3: WO2014136959A1.

### Summary of Invention

### Technical Problem

With an increase in integration density of a circuit inside an electronic component in recent years, a heat dissipation member having further enhanced heat dissipation properties than ever before and a composite body to be suitably used therefor have been demanded.

In this regard, the present disclosure provides a boron nitride sintered body and a composite body which have a sufficiently high thermal conductivity. Furthermore, the present disclosure provides a manufacturing method by which such a boron nitride sintered body and a composite body can be manufactured. Furthermore, the present disclosure provides a heat dissipation member having a sufficiently high thermal conductivity by including the above-described composite body.

### Solution to Problem

According to an aspect of the present disclosure, there is provided a boron nitride sintered body including: a plurality of coarse particles each having a length of 20 $\mu$m or more; and fine particles smaller than the plurality of coarse particles, in which, when viewed in a cross-section, the plurality of coarse particles intersect with each other. The boron nitride sintered body has a region surrounded by the plurality of coarse particles and the fine particles in the region. Since such a boron nitride sintered body includes a plurality of coarse particles each having a length of 20 $\mu$m or more, the boron nitride sintered body has a high thermal conductivity as compared to the case of only including fine particles. Furthermore, since the plurality of coarse particles intersect with each other, a heat-conducting path by the plurality of coarse particles is formed, and the anisotropy of the thermal conducting properties is decreased, so that the thermal conductivity can be sufficiently increased. Note that, the length of the coarse particle in the present disclosure refers to a length of one coarse particle in a longitudinal direction in a cross-sectional image obtained with a scanning electron microscope. The term "intersect" in the present disclosure includes not only crossing in a cross shape but also crossing, for example, in a T shape.

When viewed in the cross-section of the boron nitride sintered body, three or more coarse particles may be continuous. Thereby, the heat-conducting path by the coarse particles is lengthened, and thus the thermal conductivity can be further increased. In the present disclosure, a case where "the coarse particles are continuous" includes not only a case where the coarse particles intersect with each other but also a case where the particles are in surface contact with each other and a case where end portions are in contact with each other.

When viewed in the cross-section of the boron nitride sintered body, the boron nitride sintered body has a region surrounded by the plurality of coarse particles and the fine particles in the region. Since the coarse particles are included to surround the region including the fine particles, the heat-conducting path by the coarse particles is formed in a mesh shape, so that the thermal conductivity can be sufficiently increased.

A porosity in the boron nitride sintered body may be 30 to 65% by volume. Furthermore, a bulk density may be 800 to 1500 kg/m$^3$. When at least one of the porosity and the bulk density is in this range, the resin composition can be sufficiently impregnated while sufficiently increasing the thermal conductivity. A composite body in which both an excellent thermal conductivity and excellent electrical insulation properties can be achieved at a high level can be formed with such a boron nitride sintered body.

An average pore diameter of pores in the boron nitride sintered body may be less than 5 μm. Since the size of the pores of such a boron nitride sintered body is sufficiently small, a contact area between the boron nitride particles can be sufficiently increased. Hence, the thermal conductivity can be further increased.

An orientation index of the boron nitride sintered body may be 20 or less. Thereby, the anisotropy of the thermal conducting properties can be sufficiently decreased.

According to an aspect of the present disclosure, there is provided a composite body including any of the above-described boron nitride sintered bodies and a resin filled in at least some of the pores of the boron nitride sintered body. This composite body includes the above-described boron nitride sintered body and the resin, and from this aspect, has both an excellent thermal conductivity and excellent electrical insulation properties.

According to an aspect of the present disclosure, there is provided a heat dissipation member having the above-described composite body. This heat dissipation member has the above-described composite body, and from this aspect, has a sufficiently high thermal conductivity.

According to an aspect of the present disclosure, there is provided a method for manufacturing a boron nitride sintered body, the method including a sintering step of molding and heating a blend containing a lump boron nitride powder and a sintering aid to obtain a boron nitride sintered body including coarse particles each having a length of 20 μm or more in a cross-section and fine particles smaller than the coarse particles. When viewed in the cross-section, the boron nitride sintered body has a region surrounded by the plurality of coarse particles and the fine particles in the region.

In the sintering step of the above-described manufacturing method, the boron nitride sintered body is obtained using the blend containing the lump boron nitride powder and the sintering aid. The lump boron nitride powder is basically configured by fine particles. In the sintering step, the sintering aid acts mainly on the surface of the lump boron nitride powder to promote grain growth. On the other hand, the grain growth is not promoted in the inside of the lump boron nitride powder as much as the surface thereof. Thereby, the coarse particles easily intersect with each other, and grow to surround fine particles depending on circumstances. In the boron nitride sintered body obtained through the sintering step in this way, the coarse particle are formed to surround the region including the fine particles. Thereby, the heat-conducting path by the coarse particles is formed in a cross shape or a mesh shape, and thus the thermal conductivity can be sufficiently increased.

According to an aspect of the present disclosure, there is provided a method as described above for manufacturing a boron nitride sintered body, the method including: a raw material preparation step of firing, pulverizing, and classifying a mixture containing boron carbonitride and a boron compound in a nitrogen atmosphere to obtain the lump boron nitride powder having an average particle diameter of 10 to 200 μm.

In the sintering step of the above-described manufacturing method, the boron nitride sintered body is obtained using the blend containing the lump boron nitride having a predetermined average particle diameter obtained in the raw material preparation step and the sintering aid. The lump boron nitride is basically configured by fine particles. In the sintering step, the sintering aid acts mainly on the surface of the lump boron nitride to promote grain growth. On the other hand, the grain growth is not promoted in the inside of the lump boron nitride as much as the surface thereof. Thereby, the coarse particles easily intersect with each other, and grow to surround fine particles depending on circumstances. In the boron nitride sintered body obtained through the sintering step in this way, the coarse particle are formed to surround the region including the fine particles. Thereby, the heat-conducting path by the coarse particles is formed in a cross shape or a mesh shape, and thus the thermal conductivity can be sufficiently increased.

In the above-described manufacturing method, the sintering aid contains a boron compound and a calcium compound, and the blend may contain 1 to 40 parts by mass of the boron compound and the calcium compound in total with respect to 100 parts by mass of the lump boron nitride. Thereby, the grain growth on the surface of the lump boron nitride is promoted, and thus a boron nitride sintered body including even larger coarse particles can be manufactured. Furthermore, the residual amount of the sintering aid and a component derived from the sintering aid in the boron nitride sintered body can be reduced.

The blend in the above-described manufacturing method may contain 5 to 150 atom% of calcium constituting the calcium compound with respect to 100 atom% of boron constituting the boron compound. Thereby, the grain growth on the surface of the lump boron nitride is further promoted, and thus a boron nitride sintered body including even larger coarse particles can be manufactured.

According to an aspect of the present disclosure, there is provided a method for manufacturing a composite body, the method including an impregnating step of impregnating the boron nitride sintered body obtained by any of the above-described manufacturing methods with a resin composition, the composite body including the boron nitride sintered body and a resin filled in at least some of the pores of the boron nitride sintered body. The composite body obtained by such a manufacturing method is obtained using the above-described boron nitride sintered body and the resin composition, and from this aspect, has both a sufficiently high thermal conductivity and high electrical insulation properties.

**Advantageous Effects of Invention**

According to the present disclosure, it is possible to provide a boron nitride sintered body and a composite body which have a sufficiently high thermal conductivity. Furthermore, the present disclosure can provide a manufacturing method by which such a boron nitride sintered body and a composite body can be manufactured. Furthermore, the present disclosure can provide a heat dissipation member having a sufficiently high thermal conductivity by including the above-described composite body.

**Brief Description of Drawings**

FIG. 1 is an SEM photograph showing a cross-section of an example (Example 2) of a boron nitride sintered body.
FIG. 2 is an SEM photograph (magnification: 500) showing a cross-section of a boron nitride sintered body of Example 1.
FIG. 3 is a graph showing a relation between a pore diameter and a cumulative pore volume of Example 1.
FIG. 4 is a graph showing a relation between a pore diameter and a cumulative pore volume of Example 2.
FIG. 5 is a graph showing a relation between a pore diameter and a cumulative pore volume of Example 3.
FIG. 6 is an SEM photograph (magnification: 500) showing a cross-section of a boron nitride sintered body of Example 3.
FIG. 7 is a graph showing a relation between a pore diameter and a cumulative pore volume of Comparative Example 1.
FIG. 8 is an SEM photograph (magnification: 500) showing a cross-section of a boron nitride sintered body of Comparative Example 1.

**Description of Embodiments**

Hereinafter, embodiments of the present disclosure will be described.

A boron nitride sintered body according to an embodiment includes boron nitride particles and pores. The boron nitride sintered body includes coarse particles and fine particles smaller than the coarse particles, as boron nitride particles. A coarse particle has a length of 20 $\mu$m or more. From the viewpoint of improving a thermal conductivity, the length of the coarse particle may be 20 $\mu$m or more or may be 30 $\mu$m or more. On the other hand, from the viewpoint of ease of manufacturing, the length of the coarse particle may be 500 $\mu$m or less or may be 400 $\mu$m or less. The length is a length of one coarse particle in a longitudinal direction in a cross-sectional image obtained with a scanning electron microscope. In the cross-section, the shape of the coarse particle may be a columnar shape. The three-dimensional shape of the coarse particle may be a scale shape. The cross-section may be, for example, a cut plane obtained by cutting the boron nitride sintered body using an ion milling device.

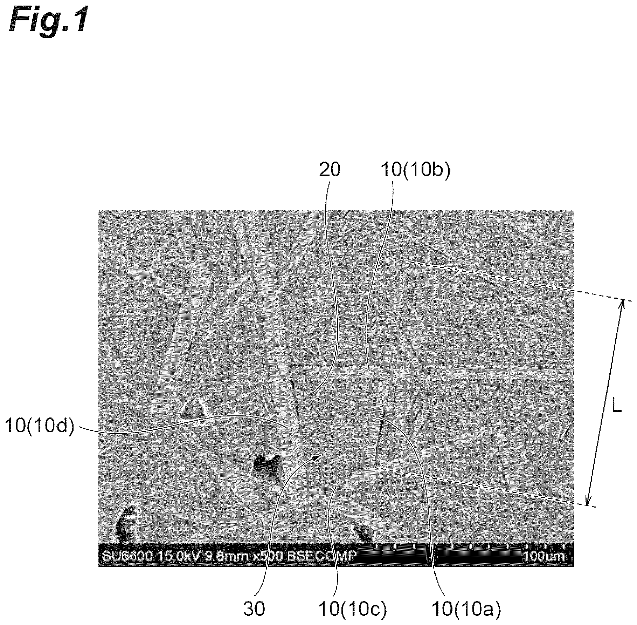

FIG. 1 is a view showing an example of a cross-sectional image of the boron nitride sintered body with a scanning electron microscope. As shown in FIG. 1, the boron nitride sintered body includes coarse particles 10 and fine particles 20 smaller than the coarse particles 10, as boron nitride particles. A coarse particle 10a that is one of the coarse particles 10 has a length L. The plurality of coarse particles 10 included in the boron nitride sintered body intersect with each other. The boron nitride sintered body has the plurality of fine particles 20 in a region 30 surrounded by a plurality of coarse particles 10a, 10b, 10c, and 10d.

In the cross-section as described above, the length of the fine particle is smaller than the length of the coarse particle. The length of the fine particle may be less than 15 $\mu$m or may be less than 10 $\mu$m. When the boron nitride sintered body includes fine particles having such a length, a porosity is decreased so that the strength can be improved. The length of the fine particle may be 1 $\mu$m or more or may be 3 $\mu$m or more. In the cross-section, the shape of the fine particle may be a columnar shape. The three-dimensional shape of the fine particle may be a scale shape or may be a columnar shape.

In the cross-section of the boron nitride sintered body, three or more, four or more, or five or more coarse particles may be continuous. Thereby, the heat-conducting path by the coarse particles is lengthened, and thus the thermal conductivity can be increased. The boron nitride sintered body may have a region surrounded by a plurality of coarse particles. This region may be formed by the coarse particles intersecting with each other or may be formed by the coarse particles being continuous with each other. The region may be formed by four coarse particles or may be formed by three or five or more coarse particles. The boron nitride sintered body includes the fine particles in this region. When the fine particles are included in the region formed by the coarse particles, the fine particles can suppress the deformation of the coarse particles in the case of applying a stress to the boron nitride sintered body. Therefore, a high strength can be maintained.

In the boron nitride sintered body, since the coarse particles intersect with each other, a heat-conducting path by the coarse particles is formed, and the anisotropy of the thermal conducting properties can be decreased. Furthermore, the heat-conducting path by the coarse particles is easily formed in a mesh shape. Owing to these factors, the thermal conductivity can be sufficiently increased, and the anisotropy of the thermal conducting properties can be decreased. It is not necessary for all the coarse particles included in the boron nitride sintered body to intersect with each other, and it is sufficient for some of the coarse particles to intersect with each other. Furthermore, in a case where the boron nitride sintered body has a region surrounded by the plurality of coarse particles, it is not necessary for all the fine particles to be included in the region, and it is sufficient for some of the fine particles to be included in the region. Furthermore, the coarse particles and the fine particles may be in contact with each other.

The compressive strength of the boron nitride sintered body may be, for example, 0.3 MPa or more, may be 0.4 MPa or more, or may be 0.5 MPa or more. When the boron nitride sintered body has a high compressive strength, breakage when the boron nitride sintered body is used as a member can be suppressed. The compressive strength can be measured by a compression tester.

The average pore diameter of the pores included in the boron nitride sintered body may be less than 5 $\mu$m. The contact area between boron nitride particles can be sufficiently increased by decreasing the size of the pores. Accordingly, the thermal conductivity can be further increased. From the viewpoint of further increasing the thermal conductivity, the average pore diameter of the pores may be less than 4 $\mu$m. From the viewpoint of smoothly performing the impregnating of the boron nitride sintered body with the resin composition, the average pore diameter of the pores may be 0.1 $\mu$m or more or may be 0.2 $\mu$m or more.

The average pore diameter of the pores is determined using a mercury porosimeter on the basis of pore size distribution obtained when pressurization is performed while increasing a pressure from 0.0042 MPa to 206.8 MPa. When the horizontal axis is designated as the pore diameter and the vertical axis is designated as the cumulative pore volume, a pore diameter at which the cumulative pore volume reaches 50% of the total pore volume is an average pore diameter. As the mercury porosimeter, a mercury porosimeter manufactured by SHIMADZU CORPORATION can be used.

The porosity of the boron nitride sintered body, that is, the volumetric ratio of the pores in the boron nitride sintered body may be 30 to 65% by volume. The upper limit of the volumetric ratio may be 60% by volume or may be 58% by volume. When the porosity is too large, the strength of the boron nitride sintered body tends to decrease. The lower limit of the volumetric ratio may be 35% by volume or may be 40% by volume. When the porosity is too small, there is a tendency that the content of the resin when a composite body is manufactured is decreased to degrade electrical insulation properties.

A bulk density [B (kg/m$^3$)] is calculated from the volume and mass of the boron nitride sintered body, and then the porosity can be determined by Calculation Formula (1) below from this bulk density and the theoretical density [2280 (kg/m$^3$)] of boron nitride.

$$\text{Porosity (\% by volume)} = [1 - (B/2280)] \times 100 \qquad (1)$$

The bulk density B may be 800 to 1500 kg/m$^3$ or may be 1000 to 1400 kg/m$^3$. When the bulk density B is too small, the strength of the boron nitride sintered body tends to decrease. On the other hand, when the bulk density B is too large, there is a tendency that the impregnation rate of the resin is decreased to degrade the electrical insulation properties of the composite body.

The thermal conductivity of the boron nitride sintered body is 20 W/mK or more or may be 30 W/mK or more. When a boron nitride sintered body having a high thermal conductivity is used, a heat dissipation member sufficiently excellent in heat dissipation performance can be obtained. The thermal conductivity (H) can be determined by Calculation Formula (2) below.

$$H = A \times B \times C \qquad (2)$$

In Calculation Formula (2), H represents a thermal conductivity (W/(m·K)), A represents a thermal diffusivity (m²/sec), B represents a bulk density (kg/m³), and C represents a specific heat capacity (J/(kg·K)). The thermal diffusivity A can be measured by a laser flash method. The bulk density B can be determined from the volume and mass of the boron nitride sintered body. The specific heat capacity C can be measured using a differential scanning calorimeter.

The bulk density B may be 800 to 1500 kg/m³. The lower limit of the bulk density B may be 1000 kg/m³. Thereby, the thermal conductivity and the strength can be sufficiently increased. The upper limit of the bulk density B may be 1400 kg/m³ or may be 1300 kg/m³. Thereby, the resin can be sufficiently filled, so that a composite body further excellent in electrical insulation properties can be obtained.

The content of boron nitride in the boron nitride sintered body may be 90% by mass or more, may be 95% by mass or more, or may be 98% by mass or more.

The shape of the boron nitride sintered body may be, for example, a sheet shape having a thickness of 10 mm or less (thin plate shape) or may be a block shape. In the case of a block shape, the boron nitride sintered body may be cut and/or polished into a predetermined thickness to be formed in a sheet shape. However, when processing such as cutting is performed, material loss occurs. Therefore, when a sheet-shaped boron nitride sintered body is produced using a sheet-shaped molded body, material loss can be reduced. Thereby, the yield of the boron nitride sintered body and the composite body can be improved.

The orientation index of boron nitride crystals in the boron nitride sintered body may be 20 or less or may be 18 or less. Thereby, the anisotropy of the thermal conducting properties can be sufficiently decreased. The orientation index of the boron nitride sintered body may be 2 or more, may be 3 or more, or may be 4 or more. The orientation index in the present disclosure is an index for quantifying the orientation degree of boron nitride crystals. The orientation index can be calculated by a peak intensity ratio [I(002)/I(100)] of (002) plane to (100) plane of boron nitride as measured by an X-ray diffractometer.

A composite body according to an embodiment is a composite body of a boron nitride sintered body and a resin and has the above-described boron nitride sintered body and a resin filled in at least some of the pores of the boron nitride sintered body. As the resin, for example, an epoxy resin, a silicone resin, a cyanate resin, a silicone rubber, an acrylic resin, a phenolic resin, a melamine resin, a urea resin, a bismaleimide resin, unsaturated polyester, a fluorine resin, polyimide, polyamide imide, polyether imide, polybutylene terephthalate, polyethylene terephthalate, polyphenylene ether, polyphenylene sulfide, wholly aromatic polyester, polysulfone, a liquid crystal polymer, polyether sulfone, polycarbonate, a maleimide resin, a maleimide-modified resin, an ABS (acrylonitrile-butadiene-styrene) resin, an AAS (acrylonitrile-acrylic rubber-styrene) resin, an AES (acrylonitrile-ethylene-propylene-diene rubber-styrene) resin, a polyglycolic acid resin, polyphthalamide, polyacetal, and the like can be used. These may be included singly or in combination of two or more kinds thereof.

In the case of using the composite body for an insulating layer of a printed-wiring board, from the viewpoint of improving heat resistance and adhesion strength to a circuit, the resin may include an epoxy resin. In the case of using the composite body for a thermal interface material, from the viewpoint of improving heat resistance, flexibility, and adhesion to a heat sink or the like, the resin may include a silicone resin. The resin may be a cured product, or may be a semi-cured product (in a B-stage state).

The content of the boron nitride particles in the composite body may be 35 to 70% by volume or may be 40 to 65% by volume, on the basis of the total volume of the composite body. The content of the resin in the composite body may be 30 to 65% by volume or may be 35 to 60% by volume, on the basis of the total volume of the composite body. In the composite body including the boron nitride particles and the resin in such ratios, both of high electrical insulation properties and a high thermal conductivity can be achieved at a high level. From the viewpoint of further improving these properties, the porosity of the composite body may be 10% by volume or less, may be 5% by volume or less, or may be 3% by volume or less. This porosity can be determined, for example, from a bulk density $B_1$ (kg/m³) as determined from the volume and mass of the composite body and a theoretical density $B_2$ (kg/m³) of the composite body obtained when the whole pores of the boron nitride sintered body are impregnated with the resin composition.

The composite body may further include other components in addition to the boron nitride sintered body and the resin filled in the pores thereof. Examples of the other components include a curing agent, an inorganic filler, a silane coupling agent, a defoamer, a surface conditioner, a wetting and dispersing agent, and the like. The inorganic filler may include one or two or more kinds selected from the group consisting of aluminum oxide, silicon oxide, zinc oxide, silicon nitride, aluminum nitride, and aluminum hydroxide. Thereby, the thermal conductivity of the composite body can be further improved.

The composite body of the present embodiment includes the above-described boron nitride sintered body and the resin, and from this aspect, has both an excellent thermal conductivity and excellent electrical insulation properties. Therefore, the composite body can be suitably used, for example, as a heat dissipation member. The heat dissipation member may be configured by the above-described composite body, or may be configured by combining another member (for example, a metal plate such as aluminum) and the composite body.

Examples of methods for manufacturing a boron nitride sintered body, a composite body, and a heat dissipation member will be described hereinafter. A method for manufacturing a boron nitride sintered body of this example includes: a raw material preparation step of firing a mixture containing boron carbonitride and a boron compound in a nitrogen atmosphere to obtain lump boron nitride having an average particle diameter of 10 to 200 $\mu$m; and a sintering step of molding and heating a blend containing the lump boron nitride and a sintering aid to obtain a boron nitride sintered body including coarse particles each having a length of 20 $\mu$m or more in a cross-section and fine particles smaller than the coarse particles.

The boron carbonitride can be produced, for example, by a nitriding step of firing a boron carbide powder synthesized as described below in a nitrogen pressurized atmosphere. First, boric acid and acetylene black are mixed and then heated in an inert gas atmosphere at 1800 to 2400°C for 1 to 10 hours to obtain lump boron carbide. The lump boron carbide may be subjected to pulverization, washing, impurity removal, and drying to be powdered. Regarding the mixing ratio of boric acid and acetylene black, for example, the acetylene black may be 25 to 40 parts by mass with respect to 100 parts by mass of the boric acid.

The boron carbide obtained in this way is fired in a nitrogen atmosphere to prepare boron carbonitride ($B_4CN_4$). The firing temperature in the nitriding step may be 1800°C or higher or may be 1900°C or higher. Furthermore, this firing temperature may be 2400°C or lower or may be 2200°C or lower. This firing temperature may be, for example, 1800 to 2400°C.

The pressure in the nitriding step may be 0.6 MPa or more or may be 0.7 MPa or more. Furthermore, this pressure may be 1.0 MPa or less or may be 0.9 MPa or less. This pressure may be, for example, 0.6 to 1.0 MPa. When the pressure is too low, there is a tendency that the nitriding of boron carbide is difficult to proceed. On the other hand, when this pressure is too high, there is a tendency that manufacturing cost is increased. Note that, the pressure in the present disclosure is an absolute pressure.

The nitrogen gas concentration of the nitrogen atmosphere in the nitriding step may be 95% by volume or more or may be 99.9% by volume or more. The partial pressure of nitrogen may be in the above pressure range. The firing time in the nitriding step is not particularly limited as long as it is in a range in which the nitriding sufficiently proceeds, and for example, may be 6 to 30 hours or may be 8 to 20 hours.

In the raw material preparation step, the boron carbonitride obtained in the nitriding step and a boron compound are mixed. In the case of using boric acid or boron oxide as the boron compound, for example, 100 to 300 parts by mass of boric acid or boron oxide is mixed with respect to 100 parts by mass of the boron carbonitride. A mixture containing the boron carbonitride and the boron compound is fired, for example, at the atmospheric pressure or under pressure. The firing temperature may be, for example, 1800 to 2200°C. The firing time may be, for example, 0.5 to 40 hours. In this way, lump boron nitride in which scale-shaped boron nitride particles are bonded to each other is obtained.

The obtained lump boron nitride may be subjected to disintegration, pulverization, and classification as necessary. In these operations, a pulverizer, a disintegrator, and a classifier, which are generally used, can be used. For example, a ball mill, a vibrating mill, a jet mill, a sieve, a cyclone, and the like are exemplified. As described above, the lump boron nitride having an average particle diameter of 10 to 200 $\mu$m is prepared by performing particle diameter adjustment as necessary. Note that, the average particle diameter in the present disclosure is D50 (a particle diameter at which the cumulative frequency becomes 50%) as measured using a laser diffraction particle size distribution measuring machine.

In the sintering step, the lump boron nitride and a sintering aid are blended to prepare a blend. From the viewpoint of reducing the residual amount of the sintering aid and a component derived from the sintering aid in the boron nitride sintered body while sufficiently promoting the grain growth of boron nitride, the blend may contain, for example, 1 to 40 parts by mass, 2 to 38 parts by mass, or 4 to 36 parts by mass of the boron compound and the calcium compound in total, with respect to 100 parts by mass of the lump boron nitride.

The blend may contain 5 to 150 atom% or 6 to 149 atom% of calcium constituting the calcium compound with respect to 100 atom% of boron constituting the boron compound. When the blend contains boron and calcium in such a ratio, the grain growth of boron nitride can be further improved.

Examples of the boron compound include boric acid, boron oxide, borax, and the like. Examples of the calcium compound include calcium carbonate, calcium oxide, and the like. The sintering aid may contain a component other than boric acid and calcium carbonate. Examples of such a component include carbonates of alkali metals such as lithium carbonate and sodium carbonate. Furthermore, for moldability improvement, a binder may be blended in the blend. Examples of the binder include an acrylic compound and the like.

The blend may be subjected to powder pressing or die molding to obtain a molded body, or may be formed into a sheet-shaped molded body by a doctor blade method or an extrusion method. The molding pressure may be, for example, 50 to 100 MPa.

The shape of the molded body is not particularly limited, and may be, for example, a block shape or may be a sheet shape having a thickness of less than 2 mm. When a boron nitride sintered body is manufactured using a sheet-shaped molded body, the impregnating of the resin composition when a composite body is manufactured smoothly proceeds. Furthermore, as compared to a case where a block-shaped boron nitride sintered body and a block-shaped composite body are cut into a sheet shape, material loss caused by processing can be reduced in the case of using a molded body which has been formed in a sheet shape. Accordingly, a sheet-shaped boron nitride sintered body and a sheet-shaped composite body can be manufactured at a high yield.

The molded body obtained in this way is fired, for example, heating in an electric furnace. The heating temperature may be, for example, 1800°C or higher or may be 1900°C or higher. This heating temperature may be, for example, 2200°C or lower or may be 2100°C or lower. When the heating temperature is too low, there is a tendency that the grain growth does not sufficiently proceed. The heating time may be 0.5 hours or longer, may be 1 hour or longer, may be 3 hours or longer, may be 5 hours or longer, or may be 10 hours or longer. This heating time may be 40 hours or shorter, may be 30 hours or shorter, or may be 20 hours or shorter. This heating time may be, for example, 0.5 to 40 hours or may be 1 to 30 hours. When the heating time is too short, there is a tendency that the grain growth does not sufficiently proceed. On the other hand, a too long heating time tends to be disadvantageous in terms of industrial aspect. The heating atmosphere may be, for example, an inert gas atmosphere such as nitrogen, helium, or argon.

Through the above steps, a boron nitride sintered body including boron nitride particles can be obtained. The boron nitride particles in this boron nitride sintered body include coarse particles and fine particles smaller than the coarse particles. In the above-described sintering step, the sintering aid acts mainly on the surface of the lump boron nitride to promote grain growth. On the other hand, the grain growth is not promoted in the inside of the lump boron nitride as much as the surface thereof. Thereby, the plurality of coarse particles grow to surround fine particles. In the boron nitride sintered body obtained through the sintering step in this way, the plurality of coarse particle are formed to surround the region including the fine particles. Thereby, the heat-conducting path by the plurality of coarse particles is formed in a mesh shape, and the anisotropy of the thermal conducting properties can be decreased. Therefore, the boron nitride sintered body has a sufficiently high thermal conductivity.

The structure and properties of the boron nitride sintered body obtained by this manufacturing method may be the same as the contents having been described in the boron nitride sintered body according to the embodiment described above. For example, the coarse particle has a length of 20 $\mu$m or more when viewed in the cross-section of the boron nitride sintered body. The length of the coarse particle may be 20 $\mu$m or more or may be 30 $\mu$m or more. On the other hand, from the viewpoint of ease of manufacturing, the length of the coarse particle may be 500 $\mu$m or less or may be 400 $\mu$m or less. In the cross-section, the shape of the coarse particle may be a columnar shape. The three-dimensional shape of the coarse particle may be a scale shape. The boron nitride sintered body has a region surrounded by the coarse particles in the cross-section. The boron nitride sintered body includes the fine particles in this region.

In the cross-section, the length of the fine particle is smaller than the length of the coarse particle. The length of the fine particle may be less than 15 $\mu$m or may be less than 10 $\mu$m. The length of the fine particle may be 1 $\mu$m or more or may be 3 $\mu$m or more. Other structures and properties of the boron nitride sintered body are as described above.

An example of the method for manufacturing a composite body includes an impregnating step of impregnating a boron nitride sintered body with a resin composition. The boron nitride sintered body may be manufactured by the above-described method. The resin composition may contain a resin component, a curing agent, and a solvent, from the viewpoint of improving fluidity and handleability. Furthermore, the resin composition may contain an inorganic filler, a silane coupling agent, a defoamer, a surface conditioner, a wetting and dispersing agent, and the like, in addition to those components.

As the resin component, for example, those which become the resin having been exemplified in the above description of the composite body by a curing or semi-curing reaction can be used. Examples of the solvent include aliphatic alcohols such as ethanol and isopropanol, ether alcohols such as 2-methoxy ethanol, 1-methoxy ethanol, 2-ethoxy ethanol, 1-ethoxy-2-propanol, 2-butoxyethanol, 2-(2-methoxyethoxy)ethanol, 2-(2-ethoxyethoxy)ethanol, and 2-(2-butoxyethoxy)ethanol, glycol ethers such as ethylene glycol monomethyl ether and ethylene glycol monobutyl ether, ketones such as acetone, methyl ethyl ketone, methyl isobutyl ketone, and diisobutyl ketone, and hydrocarbons such as toluene and xylene. These may be included singly or in combination of two or more kinds thereof.

The impregnating is performed by attaching the resin composition to the boron nitride sintered body. For example, the boron nitride sintered body may be immersed in the resin composition. The impregnating may be performed in the state of the boron nitride sintered body being immersed under a pressurized or depressurized condition. In this way, the resin can be filled in the pores of the boron nitride sintered body.

The impregnating step may be performed using the inside of an impregnating apparatus including an airtight container. As an example, the impregnating may be performed inside the impregnating apparatus under a depressurized condition, and then the impregnating may be performed under a pressurized condition by increasing the pressure inside the impregnating apparatus to be higher than the atmospheric pressure. By performing both the depressurized condition and the pressurized condition in this way, the resin can be sufficiently filled in the pores of the boron nitride sintered body. The depressurized condition and the pressurized condition may be repeated multiple times. The impregnating step may be performed while heating. The resin composition impregnated in the pores of the boron nitride sintered body becomes a resin (a cured product or a semi-cured product) after curing or semi-curing proceeds or the solvent volatilizes. In this way, a composite body having the boron nitride sintered body and a resin filled in the pores thereof is obtained. It is not necessary to fill the resin in all of the pores, and the resin may not be filled in some of the pores. The boron nitride sintered body and the composite body may include both of closed pores and open pores.

The method may include a curing step of curing the resin filled in the pores after the impregnating step. In the curing step, for example, the composite body filled with the resin is extracted from the impregnating apparatus, and then the resin is cured or semi-cured by heating and/or light irradiation depending on the type of the resin (or a curing agent to be added as necessary).

The composite body obtained in this way is obtained using the above-described boron nitride sintered body, and from this aspect, has a sufficiently high thermal conductivity. Furthermore, since the resin is filled in the pores of the boron nitride sintered body, the composite body is also excellent in electrical insulation properties. The composite body may be used directly as a heat dissipation member, or may be subjected to processing into a predetermined shape and used as a heat dissipation member.

Hereinbefore, several embodiments have been described, but the present disclosure is not intended to be limited to the above-described embodiments at all. For example, in the sintering step, a boron nitride sintered body may be obtained using a hot press in which molding and sintering are simultaneously performed. Furthermore, in the sintering step, a commercially available lump boron nitride powder may be used instead of the lump boron nitride obtained in the nitriding step and the raw material preparation step.

**Examples**

The contents of the present disclosure will be more specifically described with reference to Examples and Comparative Examples; however, the present disclosure is not limited to the following Examples.

[Boron nitride sintered body]

(Example 1)

<Production of boron nitride sintered body>

100 parts by mass of orthoboric acid manufactured by Nippon Denko Co., Ltd. and 35 parts by mass of acetylene black (trade name: HS100) manufactured by Denka Company Limited were mixed using a Henschel mixer. The obtained mixture was filled in a graphite crucible and heated in an arc furnace in an argon atmosphere at 2200°C for 5 hours to obtain lump boron carbide ($B_4C$). The obtained lump product was coarsely pulverized with a jaw crusher to obtain a coarse powder. This coarse powder was further pulverized with a ball mill having silicon carbide beads ($\phi$10 mm) to obtain a pulverized powder. The carbon amount of the obtained boron carbide powder was 19.9% by mass. The carbon amount was measured with a carbon/sulfur simultaneous analyzer.

The prepared boron carbide powder was filled in a boron nitride crucible. Thereafter, the crucible was heated for 10 hours using a resistance heating furnace in a nitrogen gas atmosphere under the conditions of 2000°C and 0.85 MPa. In this way, a fired product containing boron carbonitride ($B_4CN_4$) was obtained.

100 parts of the synthesized boron carbonitride and 100 parts of boric acid were mixed using a Henschel mixer and then filled in a boron nitride crucible, and the crucible was heated using a resistance heating furnace in a nitrogen gas atmosphere under the condition of a pressure of 0.3 MPa from room temperature to 1000°C at a temperature increasing rate of 10°C/min and from 1000°C to a retention temperature of 2000°C at a temperature increasing rate of 2°C/min. Heating was performed at the retention temperature of 2000°C for a retention time of 5 hours to synthesize a lump boron nitride in which primary particles aggregated.

The synthesized lump boron nitride was pulverized with a Henschel mixer and classified using a sieve mesh with a nylon sieve having a mesh size of 90 $\mu$m to obtain a lump boron nitride powder as fractions passing through the sieve. The particle size distribution of this lump boron nitride powder was measured using a laser diffraction particle size distribution measuring machine (manufactured by NIKKISO CO., LTD., MICROTRAC MT3300). The D50 (a particle diameter at which the cumulative frequency becomes 50%) was 33 $\mu$m.

Powdery boric acid and powdery calcium carbonate were blended to prepare a sintering aid. Upon the preparation, 93 parts by mass of calcium carbonate was blended with respect to 100 parts by mass of boric acid. Regarding the atomic ratio of boron and calcium at this time, the atomic ratio of calcium was 57 atom% with respect to 100 atom% of boron. 16 parts by mass of the sintering aid was blended with respect to 100 parts by mass of the lump boron nitride and mixed using a Henschel mixer to obtain a blend.

The blend was pressurized using a powder pressing machine at 70 MPa for 30 seconds to obtain a molded body having a circular sheet shape (diameter × thickness = 30 mm × 4.8 mm). The molded body was put in a boron nitride container and introduced into a batch-type high-frequency furnace. In the batch-type high-frequency furnace, heating was performed for 5 hours under the conditions of normal pressure, a nitrogen flow rate of 5 L/min, and 2000°C. Thereafter, a boron nitride sintered body was extracted from the boron nitride container. In this way, a sheet-shaped (flat plate-shaped) boron nitride sintered body was obtained. The thickness of the boron nitride sintered body was 5 mm.

<Cross-section observation with electron microscope>

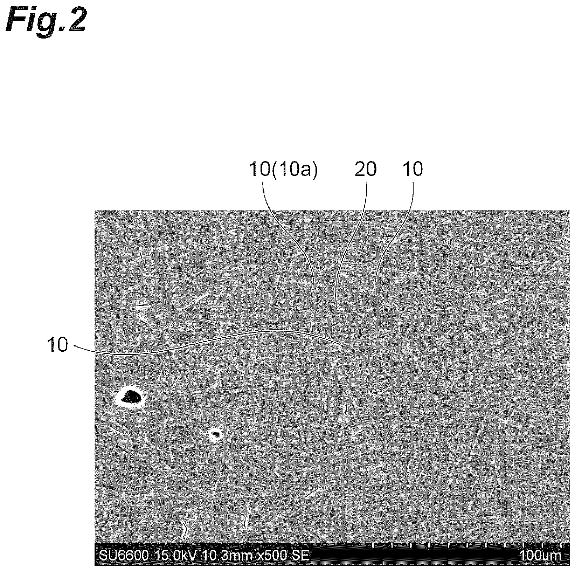

The boron nitride sintered body was cut along the thickness direction using an ion milling device to obtain a cross-section. This cross-section was observed with a scanning electron microscope (SEM). FIG. 2 is an SEM photograph (magnification: 500) showing a cross-section of a boron nitride sintered body of Example 1. As shown in FIG. 2, the boron nitride sintered body included the coarse particles 10 and the fine particles 20 smaller than the coarse particles 10, as boron nitride particles. It was confirmed that three or more coarse particles 10 having a length of 20 μm or more were continuous. The length of the coarse particle 10a along the longitudinal direction was 35 μm.

<Measurement of thickness>

The thickness of the boron nitride sintered body was measured with a micrometer.

<Measurement of thermal conductivity>

The thermal conductivity (H) of the boron nitride sintered body in the thickness direction was determined by Calculation Formula (3) below.

$$H = A \times B \times C \qquad (3)$$

In Calculation Formula (3), H represents a thermal conductivity (W/(m·K)), A represents a thermal diffusivity (m²/sec), B represents a bulk density (kg/m³), and C represents a specific heat capacity (J/(kg·K)). The thermal diffusivity A was measured using a sample, which was obtained by processing the boron nitride sintered body into a size of length × width × thickness = 10 mm × 10 mm × 2 mm, by a laser flash method. As a measurement apparatus, a xenon flash analyzer (manufactured by NETZSCH-Gerätebau GmbH, trade name: LFA447 NanoFlash) was used.

The bulk density B was calculated from the volume and mass of the boron nitride sintered body. The specific heat capacity C was measured using a differential scanning calorimeter (manufactured by Rigaku Corporation, device name: Thermo Plus Evo DSC8230). Results of the thermal conductivity H and the bulk density B are shown in Table 1.

<Measurement of average pore diameter>

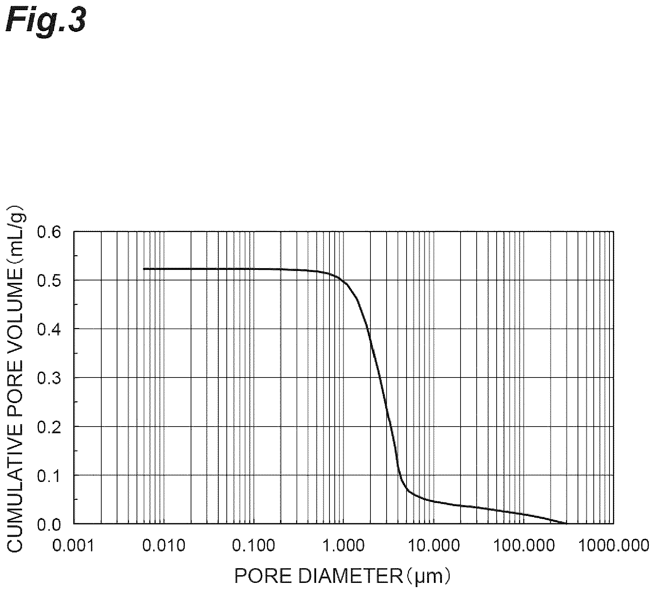

The pore volume distribution of the boron nitride sintered body was measured using a mercury porosimeter (device name: AutoPore IV 9500) manufactured by SHIMADZU CORPORATION while increasing a pressure from 0.0042 MPa to 206.8 MPa. FIG. 3 is a graph showing a relation between a pore diameter and a cumulative pore volume of Example 1. A pore diameter at which the cumulative pore volume reaches 50% of the total pore volume was regarded as the "average pore diameter", on the basis of the measurement results. Results are shown in Table 1.

<Measurement of porosity>

The volume and mass of the boron nitride sintered body were measured, and the bulk density B (kg/m³) was calculated from the volume and mass. The porosity was determined by Calculation Formula (4) below from the bulk density B calculated as described above and the theoretical density (2280 kg/m³) of boron nitride. Results were as shown in Table 1.

$$\text{Porosity (\% by volume)} = [1 - (B/2280)] \times 100 \qquad (4)$$

<Measurement of orientation index>

The orientation index [I(002)/I(100)] of the boron nitride sintered body was determined using an X-ray diffractometer (manufactured by Rigaku Corporation, trade name: ULTIMA-IV). A sample (boron nitride sintered body) set on a sample holder of the X-ray diffractometer was irradiated with X rays to perform baseline correction. Thereafter, the peak intensity ratio of (002) plane to (100) plane of boron nitride was calculated. This peak intensity ratio was regarded as the orientation index [I(002)/I(100)]. Results were as shown in Table 1.

<Measurement of compressive strength>

The compressive strength at 200°C was determined by the following procedures. The boron nitride sintered body was processed to produce a measurement sample having a prism shape (10 mm × 10 mm × 4 mm). The compressive strength was measured using a compression tester (manufactured by SHIMADZU CORPORATION, trade name: Autograph AG-X) under a condition of a compression rate of 1 mm/min. Results were as shown in Table 1.

(Example 2)

A boron nitride sintered body was manufactured by the same procedures as in Example 1, except that 49 parts by mass of powdery calcium carbonate was blended with respect to 100 parts by mass of powdery boric acid to prepare a sintering aid, and 15 parts by mass of this sintering aid was blended with respect to 100 parts by mass of lump boron nitride.

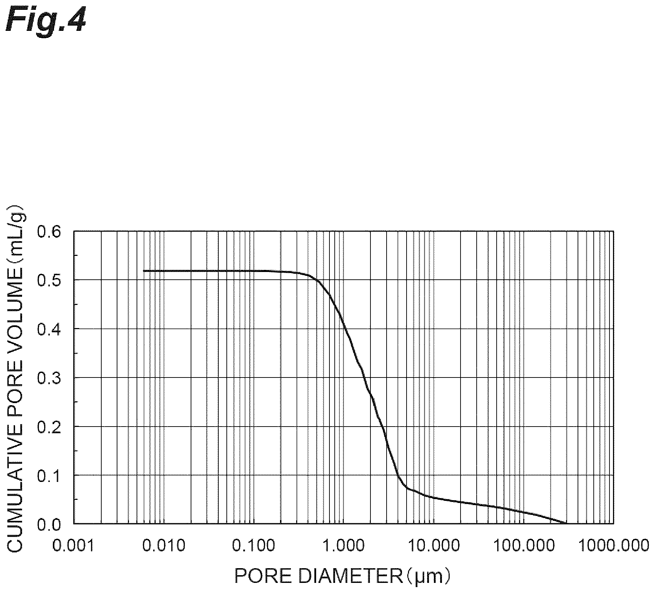

Each measurement and the cross-section observation with an electron microscope were performed in the same manner as in Example 1. Measurement results were as shown in Table 1. FIG. 4 is a graph showing a relation between a pore diameter and a cumulative pore volume of Example 2. FIG. 1 is an SEM photograph (magnification: 500) showing a cross-section of a boron nitride sintered body of Example 2. As shown in FIG. 1, the boron nitride sintered body included the coarse particles 10 and the fine particles 20 smaller than the coarse particles 10, as boron nitride particles. The coarse particle 10 had a length of 20 $\mu$m or more, and the length L of the coarse particle 10a along the longitudinal direction was 112 $\mu$m. It was confirmed that four or more coarse particles 10 having a length of 20 $\mu$m or more were continuous. Furthermore, the boron nitride sintered body had a large number of fine particles 20 in the region 30 surrounded by four coarse particles 10a, 10b, 10c, and 10d.

(Example 3)

A boron nitride sintered body was manufactured by the same procedures as in Example 1, except that 139 parts by mass of powdery calcium carbonate was blended with respect to 100 parts by mass of powdery boric acid to prepare a sintering aid, and 15 parts by mass of this sintering aid was blended with respect to 100 parts by mass of lump boron nitride.

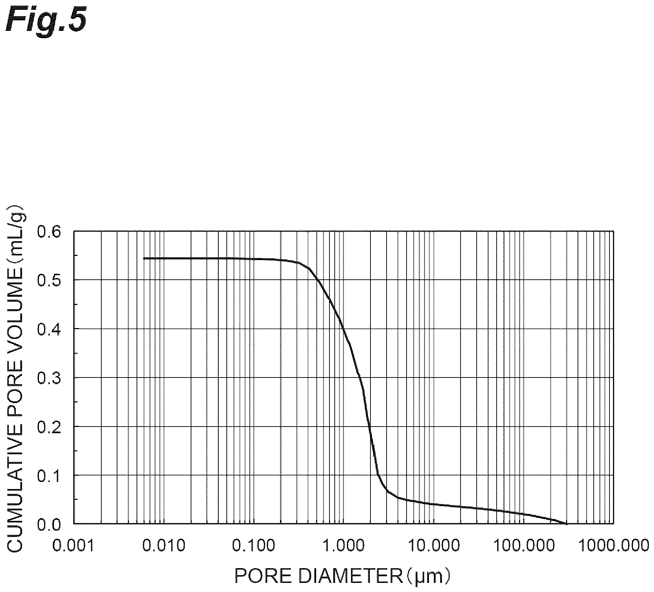

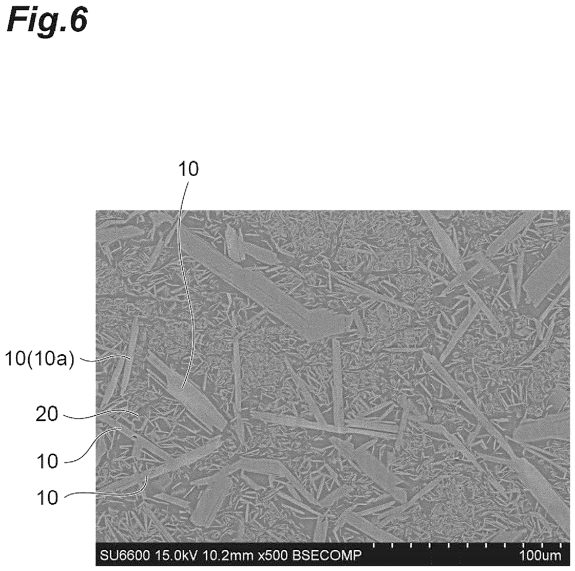

Each measurement and the cross-section observation with an electron microscope were performed in the same manner as in Example 1. Measurement results were as shown in Table 1. FIG. 5 is a graph showing a relation between a pore diameter and a cumulative pore volume of Example 3. FIG. 6 is an SEM photograph (magnification: 500) showing a cross-section of a boron nitride sintered body of Example 3. As shown in FIG. 6, the boron nitride sintered body included the coarse particles 10 and the fine particles 20 smaller than the coarse particles 10, as boron nitride particles. The coarse particle 10 had a length of 20 $\mu$m or more, and the length of the coarse particle 10a along the longitudinal direction was 41 $\mu$m. It was confirmed that three or more coarse particles 10 having a length of 20 $\mu$m or more were continuous.

(Comparative Example 1)

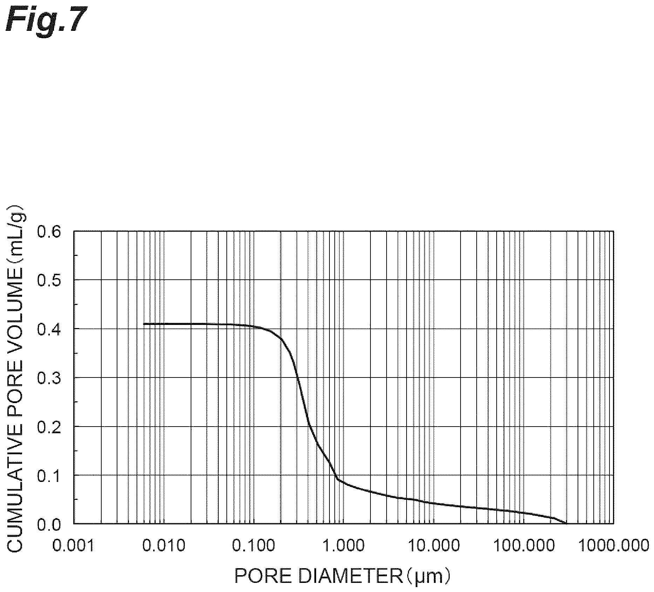

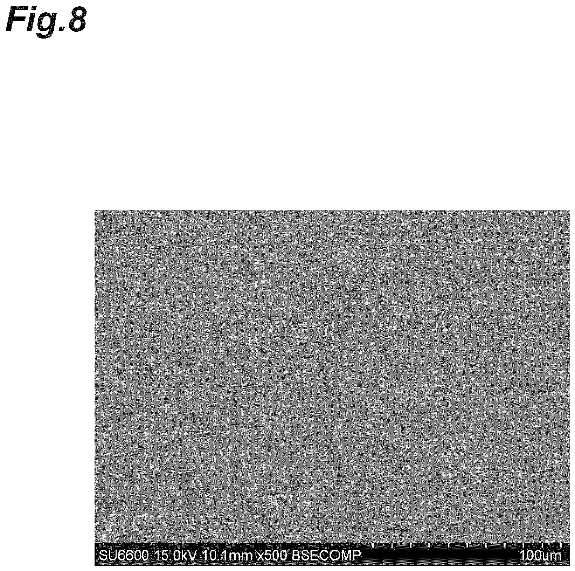

A boron nitride sintered body was manufactured by the same procedures as in Example 1, except that a sintering aid was not added. Each measurement and the cross-section observation with an electron microscope were performed in the same manner as in Example 1. Measurement results were as shown in Table 1. FIG. 7 is a graph showing a relation between a pore diameter and a cumulative pore volume of Comparative Example 1. FIG. 8 is an SEM photograph (magnification: 500) showing a cross-section of a boron nitride sintered body of Comparative Example 1. As shown in FIG. 8, the boron nitride sintered body of Comparative Example 1 did not include coarse particles.

[Table 1]

| | Thermal conductivity [W/m·K] | Average pore diameter [μm] | Porosity [% by volume] | Bulk density [kg/m$^3$] | Orientation index | Compressive strength [MPa] |
|---|---|---|---|---|---|---|
| Example 1 | 35 | 2.8 | 55 | 1025 | 14 | 0.6 |
| Example 2 | 34 | 2.1 | 54 | 1040 | 15 | 0.7 |
| Example 3 | 27 | 1.7 | 56 | 1012 | 13 | 0.6 |
| Comparative Example 1 | 2 | 0.4 | 53 | 1080 | 11 | 0.9 |

[Composite body]

<Production of composite body>

In an impregnating apparatus in which the pressure was controlled to 0.03 kPa, each of the boron nitride sintered bodies of Examples 1 to 3 and Comparative Example 1 was immersed in a resin composition containing an epoxy resin (manufactured by Mitsubishi Chemical Corporation, trade name: Epikote 807) and a curing agent (manufactured by Nippon Synthetic Chemical Industry Co., Ltd., trade name: Akumex H-84B) to impregnate the boron nitride sintered body with the resin composition. After the impregnating, the resin was cured by heating at the atmospheric pressure and at a temperature of 150°C for 60 minutes to obtain a composite body. This composite body had the thickness and the thermal conductivity that were equal to those of the boron nitride sintered body. Therefore, the composite body is useful as a heat dissipation member of an electronic component.

<Measurement of thickness>

The thickness of the composite body was measured with a micrometer.

<Measurement of thermal conductivity>

The thermal conductivity (H) of the composite body in the thickness direction was determined by Calculation Formula (4) below.

$$H_1 = A_1 \times B_1 \times C_1 \qquad (4)$$

In Calculation Formula (4), $H_1$ represents a thermal conductivity (W/(m·K)), $A_1$ represents a thermal diffusivity (m$^2$/sec), $B_1$ represents a bulk density (kg/m$^3$), and $C_1$ represents a specific heat capacity (J/(kg·K)). The thermal diffusivity A was measured using a sample, which was obtained by processing the composite body into a size of length × width × thickness = 10 mm × 10 mm × 2 mm, by a laser flash method. As a measurement apparatus, a xenon flash analyzer (manufactured by NETZSCH-Gerätebau GmbH, trade name: LFA447 NanoFlash) was used. The bulk density $B_1$ was calculated from the volume and mass of the composite body. The specific heat capacity $C_1$ was measured using a differential scanning calorimeter (manufactured by Rigaku Corporation, device name: Thermo Plus Evo DSC8230).

<Measurement of porosity>

The porosity of the composite body was calculated from the bulk density $B_1$ (kg/m$^3$) as determined from the volume and mass of the composite body and the theoretical density $B_2$ (kg/m$^3$) obtained when the whole pores of the boron nitride sintered body were impregnated with the resin composition, on the basis of Calculation Formula (5) below.

$$\text{Porosity (\% by volume) of composite body} = [1 - (B_1/B_2)] \times 100$$

$$\cdots (5)$$

Note that, the theoretical density $B_2$ (kg/m$^3$) obtained when the whole pores of the boron nitride sintered body were impregnated with the resin composition was calculated from the bulk density B (kg/m$^3$) of the boron nitride sintered body, the porosity P (% by volume) of the boron nitride sintered body, and the theoretical density (1240 kg/m$^3$) of the resin composition, on the basis of Calculation Formula (6) below.

$$\text{Theoretical density } B_2 \text{ (kg/m}^3\text{)} = B + P/100 \times 1240 \quad (6)$$

<Measurement of dielectric breakdown voltage>

The dielectric breakdown voltage of the composite body obtained as described above was evaluated. Specifically, two sheets of conductive tape were pasted on both surface of the composite body to prepare a measurement sample. The dielectric breakdown voltage was measured for the obtained measurement sample according to JIS C2110-1:2016 using a withstand voltage tester (manufactured by KIKUSUI ELECTRONICS CORPORATION, device name: TOS-8700). Results of the thermal conductivity, the bulk density, the porosity, and the dielectric breakdown voltage of the composite body were as shown in Table 2.

[Table 2]

| | Thermal conductivity [W/m·K] | Bulk density [kg/m$^3$] | Porosity [% by volume] | Dielectric breakdown voltage [kV] |
|---|---|---|---|---|
| Example 1 | 34 | 1663 | 2.6 | 4.3 |
| Example 2 | 33 | 1644 | 4.1 | 5.0 |
| Example 3 | 27 | 1589 | 6.6 | 5.2 |
| Comparative Example 1 | 1 | 1613 | 6.9 | 5.8 |

The dielectric breakdown voltage of the composite body of each Example was sufficiently high. From these results, it was confirmed that the composite body of each Example has both an excellent thermal conductivity and excellent electrical insulation properties.

**Industrial Applicability**

According to the present disclosure, there are provided a boron nitride sintered body and a composite body which are thin and suitable as a member of an electronic component and the like, and manufacturing methods therefor. Furthermore, a heat dissipation member which is suitable as a member of an electronic component and the like is provided.

**Reference Signs List**

10, 10a, 10b, 10c, 10d: coarse particle, 20: fine particle, 30: region.

**Claims**

1. A boron nitride sintered body comprising:

   a plurality of coarse particles (10) each having a length of 20 $\mu$m or more; and
   fine particles (20) smaller than the plurality of coarse particles (10),
   wherein, when viewed in a cross-section, the plurality of coarse (10) particles intersect with each other, and the boron nitride sintered body has a region (30) surrounded by the plurality of coarse particles (10) and the fine particles (20) in the region (30), and
   wherein the thermal conductivity of the boron nitride sintered body is 20 W/mK or more.

2. The boron nitride sintered body according to claim 1,
   wherein, when viewed in the cross-section, three or more coarse particles (10) are continuous.

3. The boron nitride sintered body according to claim 1 or 2, wherein a porosity is 30 to 65% by volume.

4. The boron nitride sintered body according to any one of claims 1 to 3, wherein a bulk density is 800 to 1500 kg/m$^3$.

5. The boron nitride sintered body according to any one of claims 1 to 4, wherein an average pore diameter of pores is less than 5 $\mu$m.

6. The boron nitride sintered body according to any one of claims 1 to 5, wherein an orientation index is 20 or less.

7. A composite body comprising:

   the boron nitride sintered body according to any one of claims 1 to 6; and
   a resin filled in at least some of pores of the boron nitride sintered body.

8. A heat dissipation member comprising the composite body according to claim 7.

9. A method for manufacturing a boron nitride sintered body, the method comprising:

   a sintering step of molding and heating a blend containing a lump boron nitride powder and a sintering aid to obtain a boron nitride sintered body including coarse particles (10) each having a length of 20 $\mu$m or more in a cross-section and fine particles (20) smaller than the coarse particles (10),
   wherein, when viewed in the cross-section, the boron nitride sintered body has a region (30) surrounded by the plurality of coarse particles (10) and the fine particles (20) in the region (30) , and
   wherein the thermal conductivity of the boron nitride sintered body is 20 W/mK or more.

10. The method for manufacturing the boron nitride sintered body according to claim 9, the method comprising:
a raw material preparation step of firing a mixture containing boron carbonitride and a boron compound in a nitrogen atmosphere to obtain the lump boron nitride powder having an average particle diameter of 10 to 200 $\mu$m.

11. The method for manufacturing the boron nitride sintered body according to claim 10,
wherein the sintering aid contains a boron compound and a calcium compound, and the blend contains 1 to 40 parts by mass of the boron compound and the calcium compound in total with respect to 100 parts by mass of the lump boron nitride.

12. The method for manufacturing the boron nitride sintered body according to claim 11,
wherein the blend contains 5 to 150 atom% of calcium constituting the calcium compound with respect to 100 atom% of boron constituting the boron compound.

13. A method for manufacturing a composite body, the method comprising:
an impregnating step of impregnating the boron nitride sintered body obtained by the method for manufacturing according to any one of claims 9 to 12 with a resin composition, the composite body having the boron nitride sintered body and a resin filled in at least some of pores of the boron nitride sintered body.


**Patentansprüche**

1. Bornitrid-Sinterkörper, umfassend:

   eine Vielzahl grober Partikel (10), die jeweils eine Länge von 20 $\mu$m oder mehr aufweisen; und
   feine Partikel (20), die kleiner sind als die Vielzahl grober Partikel (10),
   wobei sich die Vielzahl grober Partikel (10) im Querschnitt gesehen überkreuzt und der Bornitrid-Sinterkörper einen Bereich (30) aufweist, der von der Vielzahl grober Partikel (10) und den feinen Partikeln (20) in dem Bereich (30) umgeben ist, und
   wobei die Wärmeleitfähigkeit des Bornitrid-Sinterkörpers 20 W/mK oder mehr beträgt.

2. Bornitrid-Sinterkörper gemäß Anspruch 1,
wobei im Querschnitt gesehen drei oder mehr grobe Partikel (10) zusammenhängend sind.

3. Bornitrid-Sinterkörper gemäß Anspruch 1 oder 2, wobei die Porosität 30 bis 65 Volumenprozent beträgt.

4. Bornitrid-Sinterkörper gemäß einem der Ansprüche 1 bis 3, wobei die Schüttdichte 800 bis 1500 kg/m$^3$ beträgt.

5. Bornitrid-Sinterkörper gemäß einem der Ansprüche 1 bis 4, wobei der mittlere Porendurchmesser der Poren weniger als 5 $\mu$m beträgt.

6. Bornitrid-Sinterkörper gemäß einem der Ansprüche 1 bis 5, wobei der Orientierungsindex 20 oder weniger beträgt.

7. Verbundkörper, umfassend:

   den Bornitrid-Sinterkörper gemäß einem der Ansprüche 1 bis 6; und
   ein Harz, das in mindestens einigen der Poren des Bornitrid-Sinterkörpers gefüllt ist.

8. Wärmeableitungselement, umfassend den Verbundkörper gemäß Anspruch 7.

9. Verfahren zur Herstellung eines Bornitrid-Sinterkörpers, wobei das Verfahren umfasst:

   einen Sinterschritt, bei dem eine Mischung, die ein Bornitridpulverklumpen und ein Sinterhilfsmittel enthält, geformt und erwärmt wird, um einen Bornitrid-Sinterkörper zu erhalten, der grobe Partikel (10), die in einem Querschnitt jeweils eine Länge von 20 $\mu$m oder mehr aufweisen, und feine Partikel (20), die kleiner als die groben Partikel (10) sind, enthält,
   wobei der Bornitrid-Sinterkörper im Querschnitt gesehen einen Bereich (30) aufweist, der von der Vielzahl grober Partikel (10) und den feinen Partikeln (20) in dem Bereich (30) umgeben ist, und
   wobei die Wärmeleitfähigkeit des Bornitrid-Sinterkörpers 20 W/mK oder mehr beträgt

10. Verfahren zur Herstellung des Bornitrid-Sinterkörpers gemäß Anspruch 9, wobei das Verfahren umfasst:
    einen Schritt zur Herstellung des Rohmaterials, bei dem eine Mischung, die Borcarbonitrid und eine Borverbindung enthält, in einer Stickstoffatmosphäre gebrannt wird, um den Bornitridpulverklumpen mit einem mittleren Partikeldurchmesser von 10 bis 200 $\mu$m zu erhalten.

11. Verfahren zur Herstellung des Bornitrid-Sinterkörpers gemäß Anspruch 10,
    wobei das Sinterhilfsmittel eine Borverbindung und eine Kalziumverbindung enthält und die Mischung insgesamt 1 bis 40 Massenteile der Borverbindung und der Kalziumverbindung, bezogen auf 100 Massenteile des Bornitrid-Klumpens, enthält.

12. Verfahren zur Herstellung des Bornitrid-Sinterkörpers gemäß Anspruch 11,
    wobei die Mischung 5 bis 150 Atom-% Kalzium, das die Kalziumverbindung bildet, bezogen auf 100 Atom-% Bor, das die Borverbindung bildet, enthält.

13. Verfahren zur Herstellung eines Verbundkörpers, wobei das Verfahren umfasst:
    einen Imprägnierschritt, bei dem der Bornitrid-Sinterkörper, erhältlich durch das Verfahren zur Herstellung gemäß einem der Ansprüche 9 bis 12, mit einer Harzzusammensetzung imprägniert wird, wobei der Verbundkörper den Bornitrid-Sinterkörper und ein Harz aufweist, das in mindestens einigen der Poren des Bornitrid-Sinterkörpers gefüllt ist.

**Revendications**

1. Corps fritté au nitrure de bore comprenant :

   une pluralité de particules grossières (10) ayant chacune une longueur de 20 $\mu$m ou plus ; et
   des particules fines (20) plus petites que la pluralité de particules grossières (10),
   dans lequel, lorsqu'elles sont observées en coupe transversale, la pluralité de particules grossières (10) s'entrecoupent les unes les autres, et le corps fritté au nitrure de bore a une région (30) entourée par la pluralité de particules grossières (10) et les particules fines (20) dans la région (30), et
   dans lequel la conductivité thermique du corps fritté au nitrure de bore est de 20 W/mK ou plus.

**2.** Corps fritté au nitrure de bore selon la revendication 1,
dans lequel, lorsqu'elles sont observées en coupe transversale, trois particules grossières (10) ou plus sont continues.

**3.** Corps fritté au nitrure de bore selon la revendication 1 ou la revendication 2, dans lequel une porosité est de 30 à 65 % en volume.

**4.** Corps fritté au nitrure de bore selon l'une quelconque des revendications 1 à 3, dans lequel une densité apparente est de 800 à 1500 kg/m$^3$.

**5.** Corps fritté au nitrure de bore selon l'une quelconque des revendications 1 à 4, dans lequel un diamètre moyen de pores est inférieur à 5 $\mu$m.

**6.** Corps fritté au nitrure de bore selon l'une quelconque des revendications 1 à 5, dans lequel un indice d'orientation est de 20 ou moins.

**7.** Corps composite comprenant :

le corps fritté au nitrure de bore selon l'une quelconque des revendications 1 à 6 ; et
une résine remplie dans au moins certains des pores du corps fritté au nitrure de bore.

**8.** Élément de dissipation de chaleur comprenant le corps composite selon la revendication 7.

**9.** Procédé de fabrication d'un corps fritté au nitrure de bore, le procédé comprenant :

une étape de frittage consistant à mouler et à chauffer un mélange contenant une poudre d'agrégats de nitrure de bore et un auxiliaire de frittage pour obtenir un corps fritté au nitrure de bore incluant des particules grossières (10) ayant chacune une longueur de 20 $\mu$m ou plus en coupe transversale et des particules fines (20) plus petites que les particules grossières (10),
dans lequel, lorsqu'il est observé en coupe transversale, le corps fritté au nitrure de bore a une région (30) entourée par la pluralité de particules grossières (10) et les particules fines (20) dans la région (30), et
dans lequel la conductivité thermique du corps fritté au nitrure de bore est de 20 W/mK ou plus.

**10.** Procédé de fabrication du corps fritté au nitrure de bore selon la revendication 9, le procédé comprenant :
une étape de préparation de matière première consistant à enflammer un mélange contenant du carbonitrure de bore et un composé de bore dans une atmosphère d'azote pour obtenir la poudre d'agrégats de nitrure de bore ayant un diamètre moyen de particules de 10 à 200 $\mu$m.

**11.** Procédé de fabrication du corps fritté au nitrure de bore selon la revendication 10,
dans lequel l'auxiliaire de frittage contient un composé de bore et un composé de calcium, et le mélange contient 1 à 40 parties en masse du composé de bore et du composé de calcium au total par rapport à 100 parties en masse d'agrégats de nitrure de bore.

**12.** Procédé de fabrication du corps fritté au nitrure de bore selon la revendication 11,
dans lequel le mélange contient 5 à 150 % en atomes de calcium constituant le composé de calcium par rapport à 100 % en atomes de bore constituant le composé de bore.

**13.** Procédé de fabrication d'un corps composite, le procédé comprenant :
une étape d'imprégnation consistant à imprégner le corps fritté au nitrure de bore obtenu par le procédé de fabrication selon l'une quelconque des revendications 9 à 12 avec une composition de résine, le corps composite ayant le corps fritté au nitrure de bore et une résine remplie dans au moins certains des pores du corps fritté au nitrure de bore.

*Fig.1*

# Fig.2

# Fig.3

*Fig.4*

Fig.5

# Fig.6

SU6600 15.0kV 10.2mm x500 BSECOMP    100um

Fig.7

# Fig.8

SU6600 15.0kV 10.1mm x500 BSECOMP                    100um

**EP 4 084 060 B1**

**REFERENCES CITED IN THE DESCRIPTION**

**Patent documents cited in the description**

- JP 2014162697 A
- JP 2019073409 A
- WO 2014136959 A1